## Europäisches Patentamt

## European Patent Office

## Office européen des brevets

(19)

(11) Numéro de publication: **0 149 420 B1**

(12) **FASCICULE DE BREVET EUROPEEN**

(45) Date de publication du fascicule du brevet:
**24.06.87**

(51) Int. Cl.⁴: **H 01 R 11/18, G 01 R 1/067**

(21) Numéro de dépôt: **84810537.5**

(22) Date de dépôt: **05.11.84**

(54) **Réceptacle pour prise de contact pour le contrôle de circuits électriques, notamment de circuits imprimés, procédé de fabrication de ce réceptacle.**

(30) Priorité: **04.11.83 CH 5976/83**

(43) Date de publication de la demande:
**24.07.85 Bulletin 85/30**

(45) Mention de la délivrance du brevet:
**24.06.87 Bulletin 87/26**

(84) Etats contractants désignés:
**CH DE FR GB LI**

(56) Documents cités:
**CH - A - 589 947**
**DE - A - 2 615 820**
**US - A - 3 435 168**

(73) Titulaire: **Bauckhage, Reinhold, Avenue de la Poste 26, CH-2740 Moutier (CH)**

(72) Inventeur: **Bauckhage, Reinhold, Avenue de la Poste 26, CH-2740 Moutier (CH)**

(74) Mandataire: **Dubois, Jean René et al, BOVARD SA Ingénieurs-Conseils ACP Optingenstrasse 16, CH-3000 Berne 25 (CH)**

ACTORUM AG

## Description

La présente invention concerne un réceptacle pour prise de contact pour le contrôle de circuits électriques, notamment de circuits imprimés, comprenant une partie formant patte de connexion, destinée à être reliée à un conducteur électrique, et une partie formant douille présentant un trou borgne dont la paroi intérieure est galvaniquement revêtue d'un métal bon conducteur et résistant à la corrosion, ce trou borgne ayant un diamètre prédéterminé et étant destiné à recevoir une tige cylindrique arrière de la prise de contact, la dite douille et la dite patte de connexion étant faites d'une unique pièce métallique monolithique, et un passage, empruntant un perçage radial, existant entre le fond du trou et l'extérieur, dans cette unique pièce métallique.

L'invention concerne également un procédé de fabrication de ce réceptacle.

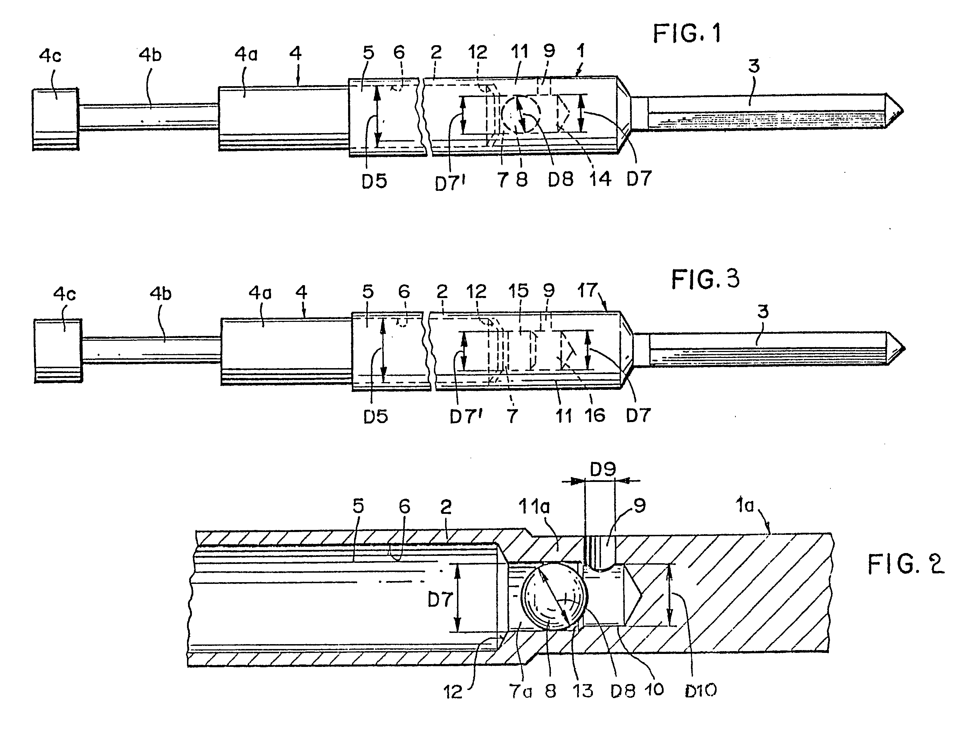

Les réceptacles de ce type font partie des dispositifs de tests, à pointe ou tige de contact, que l'on utilise notamment pour le contrôle des circuits imprimés, à l'état non-câblé, semi-câblé ou entièrement câblé. Des appareils relativement compliqués comprennent un grand nombre de telles pointes ou tiges de contact, les pointes ou tiges étant des éléments interchangeables, comprenant une partie arrière cylindrique dans laquelle est téléscopée une pointe ou une patte de forme adéquate, repoussée vers l'avant par un ressort. La tige ou pointe de contact peut être semblable à ce que l'on voit en 4 aux fig. 1 et 3, comprenant une partie arrière cylindrique 4a, engagée dans un réceptacle, une partie médiane 4b, et une partie d'extrémité, en forme de pointe, de plateau, de petite pastille, etc., 4c. La présente invention concerne toutefois uniquement le réceptacle dans lequel la tige de prise de contact est engagée, et non le dispositif complet avec la tige de prise de contact elle-même.

Un réceptacle du type précédemment mentionné doit forcément présenter une partie formant patte de connexion, du type «wire wrap» et une partie en forme de douille cylindrique destinée à recevoir la partie arrière cylindrique de la prise de contact. Il est très important que l'intérieur de cette partie en forme de douille assure un excellent contact électrique et présente une bonne résistance à la corrosion, raison pour laquelle toute la pièce, et en particulier l'intérieur de la partie-douille, est traitée galvaniquement, pour recevoir un revêtement bon conducteur et résistant à la corrosion, le plus souvent un dorage, mais dans certains cas aussi un revêtement d'argent, de nickel, de rhodium etc.

On remarque que les dimensions particulières de la partie de connexion, qui a souvent un profil carré ou rectangulaire, font qu'en aucun cas le perçage cylindrique intérieur de la douille ne peut être prolongé dans cette partie formant patte de connexion, car ce perçage intérieur de la douille a un diamètre plus grand que les dimensions de la partie formant patte de connexion. Dans la pièce finie, le trou intérieur de la partie-douille est donc un trou borgne.

Or, on sait qu'il n'est pratiquement pas possible de traiter galvaniquement, d'une façon adéquate, l'intérieur d'un trou borgne, hormis le cas où ce trou serait de très grandes dimensions.

Jusqu'à présent, pour pouvoir obtenir un intérieur de douille correctement doré, on fabriquait le réceptacle en deux parties, une partie-douille qui avait primitivement la forme d'un tube, ouvert aux deux bouts, et que l'on pouvait dorer facilement, et une partie patte de connexion, qui était également dorée préalablement et qui était ensuite chassée dans une extrémité de la partie tubulaire. Or, il serait plus avantageux et plus économique de pouvoir fabriquer un tel récepteur en une seule pièce, comprenant à la fois la partie de connexion et la partie formant douille. Ceci pose alors le problème du dorage de l'intérieur du trou borgne de la douille. Pour assurer une possibilité d'effectuer le traitement galvanique de façon adéquate, ce qui nécessite une circulation de l'électrolyte aux endroits devant être recouverts d'un revêtement, on a, dans l'art antérieur, prévu un petit perçage latéral entre l'extérieur et le fond du trou borgne de la douille, de façon que l'électrolyte puisse y circuler, lors du processus de dorage.

Ceci a permis de fabriquer des réceptacles monolithiques, qui ont été mis sur le marché sous cette forme, c'est-à-dire en présentant encore un perçage latéral entre le fond du trou de la douille et l'extérieur.

Toutefois, pour des raisons technologiques, les machines qui procèdent aux tests des circuits imprimés fonctionnent généralement sous vide, la surface cylindrique extérieure de la partie-douille du réceptacle étant montée de façon étanche à travers une plaque de l'appareil, et la partie comprenant la prise de contact se trouvant sous vide. De ce fait, la présence du perçage latéral s'est révélée gênante, car, malgré un bon ajustage de la tige arrière de la prise de contact dans la partie-douille du réceptacle, la liaison entre ces deux pièces n'est pas étanche et de l'air pouvait donc parvenir, à travers les perçages latéraux 9 des différents réceptacles, jusque dans l'espace de travail de l'appareil, qui aurait dû être maintenu sous vide. Par ailleurs, des tentatives de boucher le trou 9 simplement avec de la soudure, ou avec une matière résineuse, ont donné de mauvais résultats car ce remplissage du perçage 9 débordait dans l'intérieur de la douille et entravait la mise en place de la prise de contact dans le trou intérieur borgne du réceptacle.

Selon l'art antérieur, la réalisation d'un réceptacle monolighique, qui, malgré tout, soit facile à fabriquer et présente de bonnes qualités à l'utilisation semblait donc impossible, ou tout au moins il ne semblait pas qu'il fût possible de réaliser un tel réceptacle présentant toutes les qualités désirées tout en étant monolithique.

Pour illustrer l'art antérieur, on a découvert les trois publications CH-A-589 947, US-A-3 435 168 et DE-A-2 615 820. Toutefois, aucune de ces trois publications antérieures, ou même un enregistrement établi par combinaison de celles-ci, n'indique comment on peut arriver aux performances visées et atteintes par l'invention, à savoir:

comment on peut sans difficulté et d'une façon peu coûteuse obtenir un «réceptacle pour prise de contact...» qui à la fois:

— soit monolithique,

— présente un trou borgne muni d'un revêtement intérieur galvanique de bonne qualité,

— assure une complète étanchéité entre l'intérieur du trou borgne et la partie de la surface extérieure située au-delà de l'endroit où cette surface traversera de façon étanche une paroi de la machine, c'est-à-dire approximativement au niveau du fond du trou borgne.

Le but de la présente invention est de remédier aux inconvénients susmentionnés de l'art antérieur et de fournir un réceptacle du type précédemment défini qui, tout en étant monolithique, ne présente pas les inconvénients précédemment cités.

Conformément à l'invention, ce but est atteint par la présence des caractéristiques énoncées dans la revendication 1 annexée en ce qui concerne le réceptacle, et des caractéristiques énoncées dans la revendication 8 annexée en ce qui concerne le procédé de fabrication de ce réceptacle.

Les revendications dépendantes définissent des formes d'exécution qui sont particulièrement avantageuses quant à leur simplicité de fabrication, leur fiabilité, leur commodité d'utilisation, etc.

Le dessin annexé illustre, à titre d'exemple, des formes d'exécution de l'objet de l'invention; dans ce dessin:

la fig. 1 est une vue de face d'un réceptacle du type proposé par l'invention, qui est représenté dans l'état où il tient une prise de contact (4) qui ne fait pas, à proprement parler, partie de la présente invention,

la fig. 2 est une vue en coupe partielle à plus grande échelle d'une partie du réceptacle représenté à la fig. 1, cette fig. 2 montrant en même temps une variante de réalisation possible selon laquelle peut être réalisée la forme d'exécution générale de la fig. 1, et

la fig. 3 est une vue identique à celle de la fig. 1, montrant une autre forme d'exécution d'un réceptacle conforme à la conception particulière proposée, étant entendu que, bien que cela ne soit pas représenté, la variante particulièrement avantageuse, représentée à la fig. 2 et concernant principalement la forme générale d'exécution de la fig. 1, peut également s'appliquer à la forme générale d'exécution selon la fig. 3.

A la fig. 1, on voit un réceptacle 1 dans lequel est montée une prise de contact 4, comprenant un corps cylindrique 4a dans lequel coulisse élastiquement une tige 4b qui porte à son extrémité libre una pastille de contact 4c (cette pastille de contact pourrait également être une pointe, un bec tronconique, etc.). Il est à noter que la prise de contact 4 ne fait pas partie de l'objet de l'invention, qui concerne seulement le réceptacle 1.

On voit que ce réceptacle 1 comprend une partie en forme de douille 2 et une partie formant patte de connexion du type «wirewrap», de section rectangulaire ou carrée et dont la plus grande dimension est inférieure au diamètre intérieur D5 de la partie formant douille 2. La partie-douille 2 et la partie-patte de connexion 3 sont en une seule pièce, faite de préférence de laiton. L'intérieur de la douille 2 comporte un trou borgne 5 dont la paroi 6 doit être dorée galvaniquement ou alors recevoir un autre revêtement galvanique d'un matériau bon conducteur et résistant à la corrosion, comme par exemple l'argent, le nickel, le rhodium, etc. Ce trou borgne 5 sert à la réception de la partie arrière cylindrique 4a de la prise de contact 4. Au fond du trou borgne 5, est percé un prolongement de trou borgne 7 ayant un plus petit diamètre, qui est, à la fabrication, le diamètre D7, nettement inférieur au diamètre D5 du trou borgne de réception 5. A la jonction de ce dernier avec son prolongement 7, se forme ainsi un épaulement 12 contre lequel la partie cylindrique 4a de la prise de contact 4 vient s'appuyer, lorsque cette prise est montée dans le réceptacle terminé. Un perçage latéral 9 est prévu entre l'extérieur et le voisinage du fond du prolongement de trou borgne 7, ce perçage servant à la circulation de l'électrolyte à travers le trou borgne 5, lors du processus de dorage (ou autre processus de revêtement galvanique). Ce perçage latéral 9 est nécessaire pour l'opération de dorage, car sans lui l'électrolyte ne circulerait pas et le dorage de la paroi intérieure 6 du trou borgne 5 ne serait pas possible ou en tous les cas serait de très mauvaise qualité.

Lors de son utilisation dans un appareil de contrôle, typiquement destiné au contrôle de circuits imprimés non-câblés, semi-câblés ou entièrement câblés, la partie-douille 2 du réceptacle, parallèlement à une centaine, voire bien davantage, de dispositifs semblables, passe à travers une paroi d'appareil dans des conditions telles que ce passage est complètement étanche. La prise de contact 4 travaille alors sous vide, et il est important qu'il n'y ait pas de passage possible entre l'arrière et l'avant de la partie-douille 2, par l'intérieur de celle-ci. Or, en l'absence de moyens particuliers pour remédier à cette situation, un tel passage intérieur serait constitué par le perçage latéral 9 débouchant dans le trou borgne à l'intérieur de la partie-douille 2.

C'est la raison pour laquelle on vient forcer dans le prolongement 7 du trou borgne, une bille d'acier 8 dont le diamètre D8 est très légèrement supérieur au diamètre D7 auquel est primitivement établi le prolongement de trou borgne 7. Cette bille 8 est située entre l'embouchure du prolongement 7 dans le trou borgne 5, et la partie 14 de ce prolongement 7 où débouche le perçage latéral 9. Puisque le diamètre D8 de la bille 8 est légèrement supérieur au diamètre primitif D7 du prolongement de trou borgne 7, cette bille établit un serrage étanche qui constitue un barrage complet entre le perçage 9 (avec la partie arrière 14 du prolongement de trou borgne 7) et le trou borgne de réception 5 qui constitue l'intérieur de la partie-douille 2.

Du fait du chassage de la bille 8, le diamètre du prolongement 7, à l'endroit où a passé la bille 8, se trouve légèrement augmenté pour devenir égal à D7'. La bille 8 étant une bille d'acier, son diamètre D8 ne varie pratiquement pas lors du chassage de cette bille; par ailleurs, selon ce que seront les caractéristiques d'élasticité et de plasticité de la matière formant le corps du réceptacle, le diamètre D7' se situera, entre la valeur primitive D7 et la valeur du diamètre D8, plus ou moins près de l'un ou de l'autre (la différence entre le diamètre primitif D7 du prolongement de trou borgne 7 et le diamètre D8 de la bille 8 n'est du reste que de quelques centièmes de millimètre, typiquement de 3 centièmes de millimètre.

Au dessin, on a désigné par 11 la partie de la pièce monolithique (qui inclut la partie-douille 2 et la partie de connexion 3) qui subit la pression de chassage de la part de la bille 8. On remarque que, en cette partie 11, le corps de la pièce monolithique présente une épaisseur de paroi plus grande que dans la partie qui constitue la douille 2 proprement dite, de sorte que cette partie 11 présente la ténacité nécessaire pour résister au chassage et maintenir la pression de chassage étanche avec la bille 8.

Avec cette construction, on a un réceptacle monolithique, la partie de connexion 3 et la partie-douille 2 étant d'une seule pièce, on peut par ailleurs effectuer l'opération de dorage (ou autres opérations de revêtement galvanique) dans de bonnes conditions, et on n'a malgré tout, dans le réceptacle terminé, aucune connexion entre la partie arrière où se situe le perçage latéral 9 et le trou borgne de réception 5 dans la partie avant, formant la douille 2. De plus, aucun résidu de produit tel que résine, soudure, etc., ne risque de se trouver dans le trou borgne de réception 5 de la douille 2, d'une façon qui pourrait entraver l'engagement adéquat de la prise de contact 4 dans le réceptacle 1. La bille 8 pourrait aussi être en un autre métal que l'acier, par exemple en laiton, ou même en matière plastique.

On considérera maintenant la fig. 2 qui, en principe, montre d'un façon plus détaillée et en coupe la partie du réceptacle 1 de la fig. 1 où se situe la bille d'obturation étanche 8. Toutefois, on a profité de cette figure de détail pour décrire une variante de la construction générale de la fig. 1, et c'est donc la partie médiane d'un réceptacle 1a, constituant une variante, qui se trouve représentée à la fig. 2. On y retrouve les mêmes éléments 2, 5, 6, 8, 9 et 12 qu'à la fig. 1, et il n'est pas nécessaire de les considérer une nouvelle fois ici de façon détaillée. On remarque toutefois que, pour avoir des conditions de construction et d'opération optimales, la partie-douille 2 a un diamètre extérieur légèrement supérieur à celui de la partie 11a dans laquelle vient se loger la bille 8 et dans laquelle est également ménagé le perçage latéral 9.

Dans cette variante d'exécution selon la fig. 2, le prolongement 7a du trou borgne 5 a exactement le même diamètre que dans la forme d'exécution précédemment considérée, mais il est moins profond sur ce diamètre-là, étant prolongé encore par un second prolongement 10 d'un diamètre encore inférieur D10. C'est dans ce second prolongement 10 que débouche le perçage latéral 9 de communication avec l'extérieur pour l'opération de dorage galvanique (ou autres traitements galvaniques similaires). Cette succession des deux prolongements de trou borgne 7a, puis 10, forme un épaulement 13 qui se situe entre l'endroit où débouche le perçage latéral 9 et l'endroit où le premier prolongement de trou borgne 7a débouche dans le trou borgne de réception 5.

Dans ces conditions, lors du chassage de la bille 8 dans l'entrée du prolongement 7a, il n'est pas nécessaire de veiller à positionner exactement la bille 8 (par exemple, à l'aide d'une butée montée sur le dispositif servant au chassage), car on peut chasser la bille 8 jusqu'à ce qu'elle vienne elle-même buter contre l'épaulement 13 précité. Ceci simplifie les opérations de fabrication du réceptacle, tout en assurant que la bille 8 reste en aval du perçage 9 (en considérant une direction de circulation qui irait de ce perçage 9 jusqu'au trou de réception 5). Par ailleurs, tout ce qui a été dit au sujet de la forme d'exécution de la fig. 1 est également valable pour la forme d'exécution de la fig. 2.

Le diamètre D8 de la bille 8 indiqué à la fig. 2 est de 0,90 mm. Le prolongement de trou borgne 7a est primitivement établi à 0,87 mm, on admet qu'après chassage de la bille 8, la partie ayant subi l'action de chassage présente un diamètre D7' d'approximativement 0,88 mm. D'autre part, le diamètre D9 du perçage latéral 9 est de 0,40 mm. Enfin, le second prolongement 10, servant à fournir l'arête de retenue 13, présente un diamètre D10 de 0,80 mm.

Concernant la variante d'exécution de la fig. 2, on note que la présence de l'épaulement de butée 13 présente l'avantage d'empêcher qu'un chassage trop poussé de la bille 8 amène celle-ci en face, ou même au-delà, du perçage latéral 9. En effet, si cela se produisait, le rôle d'étanchéisation de la bille 8 ne serait plus rempli, ou tout au moins, pour le cas où la bille serait exactement en face du perçage 9, ne serait plus rempli d'une façon aussi fiable que dans le cas de la position de bille représentée à la fig. 1. La variante de la fig. 2 élimine tout risque de ce genre.

La fig. 3 représente une autre forme d'exécution d'un réceptacle monolithique 17 conforme à la conception proposée. Cette figure 3 est très similaire à la fig. 1, et on y retrouve tous les éléments 2 à 7, sur lesquels il n'est donc pas nécessaire de revenir ici.

Par contre, dans cette forme d'exécution selon la fig. 3, la bille d'étanchéisation 8 est remplacée par un bouchon 15, de forme cylindrique, qui peut être soit métallique soit fait d'une matière présentant une élasticité souple, comme par exemple le caoutchouc, les matières plastiques souples ou encore les matières plastiques semi-souples. Le perçage latéral 9, servant à l'opération de dorage, débouche dans l'espace 16 qui est constitué par la partie du prolongement de trou borgne 7 située derrière le bouchon 15.

Le chassage du bouchon 15 ne provoque pratiquement pas d'expansion du diamètre D7 du prolongement de trou borgne 7, le serrage se faisant principalement du côté du bouchon 15. Il est à noter que, dans cette forme d'exécution selon la fig. 3, le bouchon cylindrique 15 pourrait également être enfoncé jusqu'au fond du prolongement de trou borgne 7, étant donné que sa forme cylindrique, compte tenu de sa dimension axiale et de la position du perçage radial 9 à proximité du fond du prolongement de trou borgne 16, assurerait malgré tout un «bouchage» adéquat du perçage latéral 9. En variante, non représentée, on pourrait également constituer la partie du réceptacle 17 de la fig. 3 dans laquelle se trouve le bouchon d'obturation 15 d'une manière similaire à ce que montre la fig. 2, afin que ce bouchon soit retenu en aval du perçage 9 par un épaulement tel que l'épaulement 13 de la fig. 2 (la position «aval» est admise en tenant compte d'un sens de circulation allant du perçage latéral 9 au trou borgne de réception 5). Pour le reste, ce qui a été dit en liaison avec

7 0 149 420 8

la fig. 1 et la fig. 2 est également valable pour la forme d'exécution de la fig. 3. On note que si, d'une part, un bouchon cylindrique de la forme du bouchon 15 peut paraître particulièrement adéquat pour assurer une bonne étanchéité dans un trou cylindrique, d'autre part, la mise en place d'une pièce ayant la forme du bouchon 15 est moins facile, car il s'agit que le bouchon 15 soit positionné adéquatement juste en face du prolongement de trou borgne 7 au moment où il va être chassé dans ce dernier. Avec une bille telle que la bille 8 cet inconvénient ne se présente pas; d'autre part, on sait que le serrage d'une bille dans un conduit cylindrique fournit aussi une très bonne étanchéité.

A la fig. 3, la partie de réceptacle 17, au droit de laquelle se fait le serrage d'étanchéité au moyen du bouchon 15, présente le même diamètre extérieur que la partie-douille 2, il est clair qu'elle pourrait également être amincie, comme on le voit en 11a à la fig. 2, indépendamment du fait que l'on adopte ou non, pour cette forme d'exécution de la fig. 3, la disposition de deux prolongements de trou borgne successifs et de diamètres décroissants, représentée à la fig. 2.

## Revendications

1. Réceptacle pour prise de contact (4) pour le contrôle de circuits électriques, notamment de circuits imprimés, comprenant une partie formant patte de connexion (3), destinée à être reliée à un conducteur électrique, et une partie formant douille (2) présentant un trou borgne (5) dont la paroi intérieure (6) est galvaniquement revêtue d'un métal bon conducteur et résistant à la corrosion, ce trou borgne (5) ayant un diamètre prédéterminé (D5) et étant destiné à recevoir une tige cylindrique arrière de la prise de contact (4), la dite douille (2) et la dite patte de connexion (3) étant faites d'une unique pièce métallique monolithique, et un passage, empruntant un perçage radial (9), existant entre le fond du trou borgne et l'extérieur, dans cette unique pièce métallique, caractérisé en ce qu'un prolongement (7, 14; 7a, 10; 7, 16) de trou borgne, d'un diamètre (D7', D7; D7', D10; D7, D7) inférieur au diamètre (D5) du dit trou borgne de réception (5), est établi dans le fond de ce dernier, le dit perçage radial (9) débouchant dans le fond du dit prolongement (7, 14; 7a, 10; 7, 16), et un bouchon (8; 15) étant disposé dans le dit prolongement du trou borgne de façon à établir un barrage étanche entre le dit trou borgne de réception (5) et le dit perçage radial (9).

2. Réceptacle selon la revendication 1, caractérisé en ce que le dit bouchon est une bille métallique (8) d'un diamètre (D8) inférieur à celui (D5) du dit trou borgne de réception, et avoisinant, avec un excédent propre à un chassage, celui (D7) du dit prolongement (7; 7a) de trou borgne, dans l'entrée duquel cette bille (8) est chassée, en avant de l'endroit où le dit perçage radial (9) y débouche.

3. Réceptacle selon la revendication 2, caractérisé en ce que le dit prolongement de trou borgne (7a, 10) est formé d'une première partie (7a) dont le diamètre (D7') est avoisiné avec excédent de chassage par celui (D8) de la dite bille (8), et d'une seconde partie (10), débouchant dans le fond de la première et dont le diamètre (D10) est inférieur à celui (D7') de la dite première partie, le dit perçage radial (9) débouchant dans la dite seconde partie (10) de prolongement, et un épaulement (12), à l'endroit de jonction entre les deux dites parties (7a, 10), empêchant la pénétration de la dite bille (8) jusque dans la zone où débouche le dit perçage radial (9).

4. Réceptacle selon la revendication 2 ou la revendication 3, caractérisé en ce que la dite pièce unique est en laiton doré ou revêtu d'argent, de nickel, ou de rhodium au moins contre la paroi intérieure (6) du dit trou borgne (5) de la dite partie-douille (2), tandis que la dite bille (8) est en acier.

5. Réceptacle selon la revendication 1, caractérisé en ce que le dit bouchon (15) est cylindrique et est fait en une matière et avec un diamètre tels qu'un serrage élastique se trouve réalisé entre ce bouchon (15) et la paroi intérieure du dit prolongement de trou borgne (7), sur le diamètre intérieur (D7) de celui-ci.

6. Réceptacle selon la revendication 5, caractérisé en ce que le dit bouchon cylindrique (15) est en métal ou en un composé métallique.

7. Réceptacle selon la revendication 5, caractérisé en ce que le dit bouchon cylindrique (15) est fait d'une matière douée d'élasticité souple, ayant les particularités du caoutchouc ou des matières plastiques souples ou semi-souples.

8. Procédé de fabrication du réceptacle selon la revendication 1, caractérisé en ce qu'on façonne d'abord la dite pièce monolithique unique, comprenant la dite partie-douille (2) de prolongement et la dite partie de connexion (3), en établissant également le dit perçage radial (9) entre le fond de l'intérieur de la partie-douille et l'extérieur, on fait ensuite subir à cette pièce un traitement galvanique dans lequel l'électrolyte circule dans le dit trou borgne, en passant par le dit perçage, puis on chasse le dit bouchon dans l'entrée (7; 7a) du dit prolongement (7, 14; 7a, 10; 7, 16) du dit trou borgne (5) de la dite partie-douille (2).

9. Procédé selon la revendication 8, caractérisé en ce qu'on utilise une bille d'acier (8) pour constituer le dit bouchon que l'on chasse dans l'entrée (7) du dit prolongement (7, 14; 7a, 10) du dit trou borgne de réception.

10. Procédé selon la revendication 8 ou la revendication 9, caractérisé en ce qu'on façonne d'abord la dite pièce monolithique unique avec la forme définie à la revendication 3, puis l'on chasse la dite bille (8) ou un dit bouchon (15) jusqu'à ce qu'elle bute, ou qu'il bute, contre l'épaulement (12) formé à la jonction des deux dites parties (7a, 10) du dit prolongement (7a, 10) du trou borgne.

## Patentansprüche

1. Aufnahmeteil für einen Steckkontakt (4) zum Herstellen eines Kontaktes für die Kontrolle von elektrischen Schaltungen, insbesondere gedruckten Schaltungen, mit einem eine Verbindungslasche bildenden Verbindungteil (3), der zum Verbinden mit einem elektrischen Leiter bestimmt ist, und einem eine Buchse (2) bildenden Teil, der eine Sackbohrung (5) aufweist, deren Innenseite (6) mit einem Metall von guter Leitfähigkeit und Korrosionsbeständigkeit galvanisch ausgekleidet ist, wobei diese Sackbohrung (5) einen vorgegebenen Durchmesser (D5) aufweist und zur Aufnahme eines hinteren zylindrischen Stiftes des Steckkontaktes (4) bestimmt ist, die genannte Büchse (2) und der genannte Verbindungsteil (3) aus einem einzigen monolithischen Metallstück hergestellt sind, und eine einen Durchgang bildende seitliche radiale Bohrung (9) zwischen dem inneren und dem äusseren Ende der Sackbohrung in dem einzigen Metallstück vorhanden ist, dadurch gekennzeichnet, dass eine Verlängerung (7, 14; 7a, 10; 7, 16) der Sackbohrung mit einem kleineren Durchmesser (D7', D7; D7', D10; D7, D7) als der Durchmesser (D5) der genannten Aufnahme-Sackbohrung (5) am inneren Ende der letzteren vorhanden ist, dass die genannte radiale Bohrung (9) in den Bodenbereich der genannten Verlängerung (7, 14; 7a, 10; 7, 16) mündet und dass ein Stopfen (8; 15) in der genannten Verlängerung der Sackbohrung zum Bilden einer abdichtenden Sperre zwischen der genannten Aufnahme-Sackbohrung (5) und der genannten radialen Bohrung (9) angeordnet ist.

2. Aufnahmeteil nach Anspruch 1, dadurch gekennzeichnet, dass der genannte Stopfen eine Metallkugel (8) ist, mit einem kleineren Durchmesser (D8) als jener (D5) der Aufnahme-Sackbohrung und angenähert mit einem Presssitzübermass, gegenüber jenem (D7) der genannten Verlängerung (7; 7a) der Sackbohrung, in dessen Eingang diese Kugel (8) an eine Stelle eingepresst wurde, die sich vor der Einmündung der radialen Bohrung (9) befindet.

3. Aufnahmeteil nach Anspruch 2, dadurch gekennzeichnet, dass die genannte Verlängerung (7a, 10) der Sackbohrung einen ersten Teil (7a), dessen Durchmesser (D7') angrenzend demjenigen (D8) der genannten Kugel (8) ist, und einen in den hinteren Bereich des ersten Teiles mündenden zweiten Teil (10) aufweist, dessen Durchmesser (D10) kleiner ist als jener (D7') des genannten ersten Teiles, dass die genannte radiale Bohrung (9) in den genannten zweiten Teil (10) der Verlängerung mündet, und dass zwischen den beiden Teilen (7a, 10) eine Schulter (13) zum Verhindern des Eindringens der genannten Kugel (8) in den Mündungsbereich der genannten radialen Bohrung (9) vorhanden ist.

4. Aufnahmeteil nach Anspruch 1 oder 2, dadurch gekennzeichnet, dass das genannte einzige Stück aus vergoldetem Messing oder aus Messing hergestellt ist, wobei wenigstens die Innenseite (6) der genannten Sackbohrung (5) der Buchse (2) mit Silber, Nickel oder Rhodium ausgekleidet ist, und dass die genannte Kugel (8) aus Stahl besteht.

5. Aufnahmeteil nach Anspruch 1, dadurch gekennzeichnet, dass der genannte Stopfen (15) zylindrisch und aus einem Material und mit einem Durchmesser hergestellt ist, so dass ein elastischer Druck zwischen dem Stopfen (15) und der Innenseite der genannten Verlängerung (7) der Sackbohrung im Bereich des Innendurchmessers (D7) der Verlängerung ausgeübt wird.

6. Aufnahmeteil nach Anspruch 5, dadurch gekennzeichnet, dass der genannte zylindrische Stopfen (15) aus Metall oder einer metallischen Verbindung besteht.

7. Aufnahmeteil nach Anspruch 5, dadurch gekennzeichnet, dass der genannte zylindrische Stopfen (15) aus einem elastisch federnden Material, insbesondere aus Kautschuk oder elastischem oder halbelastischem Kunststoff hergestellt ist.

8. Verfahren zur Herstellung des Aufnahmeteils nach Anspruch 1, dadurch gekennzeichnet, dass man zuerst das genannte einzige monolithische Stück mit dem genannten Buchsenteil (2) der Verlängerung und dem genannten Verbindungsteil (3) formt, dass man auch die genannte radiale Bohrung (9) zwischen dem Boden des Innern des Buchsenteiles und der Aussenseite desselben bildet, dass man danach an diesem Stück eine galvanische Behandlung ausführt, gemäss welcher der Elektrolyt in der genannten Sackbohrung (5) durch die genannte radiale Bohrung zirkuliert, und dass man den genannten Stopfen in den Eingang (7; 7a) der genannten Verlängerung (7, 14; 7a, 10; 7, 16) der genannten Sackbohrung (5) des genannten Buchsenteiles (2) einpresst.

9. Verfahren nach Anspruch 8, dadurch gekennzeichnet, dass man eine Stahlkugel (8) zum Bilden des genannten Stopfens verwendet, den man in den Eingang (7) der genannten Verlängerung (7, 14; 7a, 10) der genannten Aufnahme-Sackbohrung einpresst.

10. Verfahren nach Anspruch 8 oder 9, dadurch gekennzeichnet, dass man zuerst das genannte einzige monolithische Stück gemäss der in dem Anspruch 3 definierten Form bildet, und dass man dann die genannte Kugel (8) oder einen genannten Stopfen (15) mit Presssitz, bis sie oder er gegen die an der Übergangsstelle zwischen den beiden genannten Teilen (7a, 10) der genannten Verlängerung (7a, 10) der Sackbohrung anstösst, einpresst.

## Claims

1. Receptacle for a plug (4) for checking electric circuits, especially printed circuits, comprising a portion forming a connection clip (3), intended to be connected to an electric conductor, and a portion forming a socket (2) having a blind hole (5), the inside wall (6) of which is electro-plated with a metal which is a good conductor and resistant to corrosion, this blind hole (5) having a predetermined diameter (D5) and being intended to receive a cylindrical rear pin of the plug (4), the said socket (2) and the said connection clip (3) being made in one single monolithic metal piece, and a passage, following a radial bore (9), existing in this single metal piece between the bottom of the blind hole and the outside, characterized in that a blind-hole extension (7, 14; 7a, 10; 7, 16), of a diameter (D7', D7; D7', D10; D7, D7) less than the diameter (D5) of the said receiving blind hole (5), is made in the bottom of the latter, the said radial bore (9) opening out into the bottom of the said extension (7, 14; 7a, 10; 7, 16), and a stopper (8; 15) being disposed in the said blind hole so as to establish a fluid-tight barrier between the said receiving blind hole (5) and the said radial bore (9).

2. Receptacle according to claim 1, characterized in that the said stopper is a metal ball (8) of a diameter (D8) less than that (D5) of the said receiving blind hole and, with an excess suitable for driving-in, close to that (D7) of the said blind hole (7; 7a), into the entrance of which this ball (8) is driven, ahead of the location where the said radial bore (9) opens out into it.

3. Receptacle according to claim 2, characterized in that the said blind hole (7a, 10) is formed of a first portion (7a), the diameter (D7') of which is verged upon, with a driving-in excess, by that (D8) of the said ball (8), and of a second portion (10), opening out into the bottom of the first portion, and the diameter (D10) of which is less than that (D7') of the said first portion, the said radial bore (9) opening out into the said second extension portion (10), and a shoulder (12), at the location of the junction between the two said portions (7a, 10), preventing the penetration of the said ball (8) as far as the zone where the said radial bore (9) opens out.

4. Receptacle according to claim 2 or claim 3, characterized in that the said single piece is of brass, gilded or coated with silver, with nickel, or with rhodium at least against the inside wall (6) of the said blind hole (5) of the said socket portion (2), while the said ball (8) is of steel.

5. Receptacle according to claim 1, characterized in that the said stopper (15) is cylindrical and is made of a material and with a diameter such that an elastic squeezing is created between this stopper (15) and the inside wall of the said blind hole (7), on the inside diameter (D7) of the latter.

6. Receptacle according to claim 5, characterized in that the said cylindrical stopper (15) is of metal or of a metallic compound.

7. Receptacle according to claim 5, characterized in that the said cylindrical stopper (15) is made of a material endowed with pliable elasticity, having the particularities of rubber or of the pliable or semi-pliable plastics materials.

8. Process for manufacturing the receptacle according to claim 1, characterized in that first the said single monolithic piece is fashioned, comprising the said extension socket portion (2) and the said connection portion (3), in likewise making the said radial bore (9) between the bottom of the inside of the socket portion and the outside, this piece is then made to undergo an electroplating treatment in which the electrolyte circulates in the said blind hole by passing through the said bore, then the said stopper is driven into the entrance (7; 7a) of the said extension (7, 14; 7a, 10; 7, 16) of the said blind hole (5) of the said socket portion (2).

9. Process according to claim 8, characterized in that a steel ball (8) is used to constitute the said stopper which is driven into the entrance (7) of the said extension (7, 14; 7a, 10) of the said receiving blind hole.

10. Process according to claim 8 or claim 9, characterized in that first the said single monolithic piece is fashioned with the shape defined in claim 3, then the said ball (8) or a said stopper (15) is driven in until it butts against the shoulder (12) formed at the junction of the two said portions (7a, 10) of the said extension (7a, 10) of the blind hole.

FIG.1

FIG.3

FIG.2